# EUROPEAN PATENT SPECIFICATION

(11) **EP 2 839 206 B1**
(45) Date of publication and mention of the grant of the patent: **02.09.2015**
(21) Application number: 13725794.5
(22) Date of filing: 16.04.2013
(51) Int. Cl.: E04D 13/00, E04F 10/08, F21S 9/03, E06B 9/386, E04B 7/16, E06B 9/24

(54) **A LIGHTING GROUP**
BELEUCHTUNGSGRUPPE
GROUPE D'ÉCLAIRAGE

(30) Priority: 17.04.2012 IT BO20120206
(43) Date of publication of application: 25.02.2015
(73) Proprietor: Gpiii S.r.l., 40014 Crevalcore (Bologna) (IT)
(72) Inventor: VINCENZI, Donato, I-44121 Ferrara (IT)
(74) Representative: Dall'Olio, Christian
(86) International application number: PCT/IB2013/053007
(87) International publication number: WO 2013/156925

(56) References cited:
- WO-A1-2010/150193
- WO-A1-2011/107918
- CN-C- 100 464 053
- DE-A1- 4 302 883
- DE-A1- 10 344 213
- DE-A1-102005 032 657
- DE-A1-102010 005 054
- DE-A1-102010 033 938
- DE-C2- 2 557 296
- DE-U1- 29 813 771
- FR-A1- 2 947 845
- JP-A- 2007 315 083
- US-A- 5 180 441
- US-A1- 2011 253 319

## Description

### FIELD OF INVENTION

The present invention relates to the technical sector concerning devices which convert solar energy into electrical energy.

### DESCRIPTION OF PRIOR ART

A device is known which converts solar energy into electrical energy, which powers a lamp for night-time illumination; the area to be illuminated is usually located where an electrical energy distribution network is absent (for example particularly difficult-to-reach and/or mountainous places).

The known conversion device comprises a first optical group and a plurality of photovoltaic cells; the first optical group is designed to convey solar rays towards the photovoltaic cells.

The lamp is provided with a source of artificial light and a housing which receives the artificial light source and which is provided with a second optical group for conveying the reflected light towards the area to be illuminated; in particular, the second optical group can be a reflective surface which clads an internal wall of the housing.

The group formed by the conversion device of solar energy into electrical energy and the lamp is however cumbersome and expansive.

Patent application US-A-2011/0253319 describes the features of the preamble of claim 1.

### SUMMARY OF THE INVENTION

The aim of the present invention consists in obviating the above-mentioned drawbacks.

The aim is attained by providing a lighting group according to claim 1.

According to claim 1, the disclosed lighting group comprises: a frame; a support which is constrained to the frame; a photovoltaic cell which is constrained to the support; an artificial light source;

in particular, the support is provided with a reflective surface arranged and conformed such as to convey solar rays towards the photovoltaic cell; the artificial light source is constrained to the support such as to emit a light beam which reflects against the reflective surface and propagates towards the outside; the support is rotatable about an axis such as to be arranged such as to maximise a quantity of solar rays which reflect against the reflective surface and are conveyed towards the photovoltaic cell, and in order to regulate the direction of the light beam emitted outwards from the artificial light source.

The lighting group of the present invention is compact and has limited costs with respect to the prior art.

It is in fact possible to constrain both the photovoltaic cell and the light source to the support. Consequently, further housings are not necessary for the light source; nor is the presence of the actual lamp pole.

The lighting group of the invention further exhibits a pleasant aesthetic aspect, differently to the prior art, and, from the architectural point of view, is optimally integrated in structures that already exist.

The group of the invention further also exhibits the advantage of performing a multiplicity of functions (for example shading) as will be more fully clarified in the following.

### BRIEF DESCRIPTION OF THE DRAWINGS

Specific embodiments of the invention will be described in the following part of the description, in accordance with what is set out in the claims and with the aid of the appended tables of drawings, in which:
figure 1 is a sectioned lateral view of a lighting group of the present invention (in which some parts have been removed better to evidence others), in a first operating situation;
figure 2 illustrates the same view as in figure 1, in a second operating situation;
figure 3 is a sectioned lateral view of a preferred embodiment of the invention;
figure 4 is a view as in figure 3, in a different operating situation;
figure 5 is a schematic plan view of a detail of a preferred embodiment of the invention;
figure 6 is a perspective view of a preferred embodiment of the invention.

### DESCRIPTION OF PREFERRED EMBODIMENTS

With reference to the accompanying figures, 1 and 10 denote a lighting group according to the present invention.

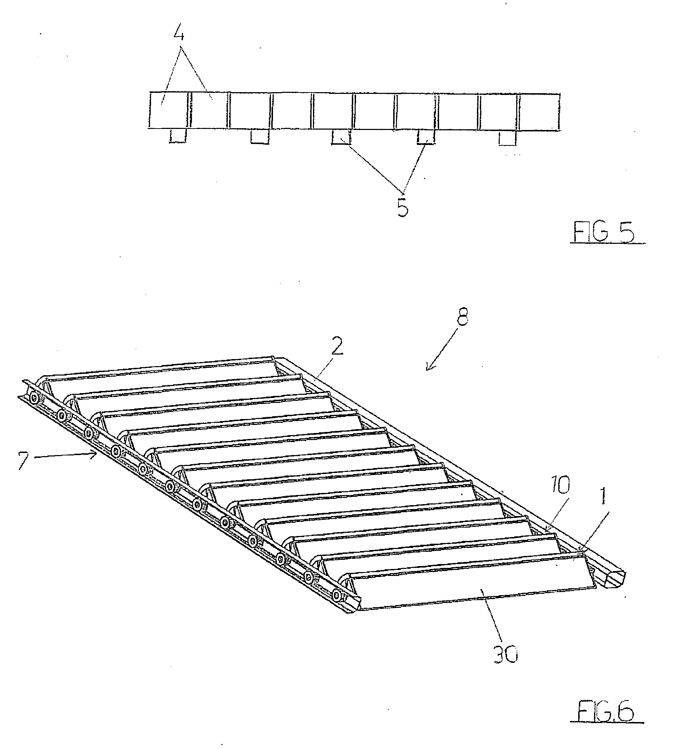

The group 1, 10 comprises: a frame 2 (visible in figure 6); a support 3 which is constrained to the frame 2; a photovoltaic cell 4 which is constrained to the support 3; an artificial light source 5.

In particular, the support 3 is provided with a reflective surface 6 arranged and conformed for conveying the solar rays R towards the photovoltaic cell 4.

The artificial light source 5 is constrained to the support 3 such as to emit a light beam 50 which reflects against the reflective surface 6 and propagates towards the outside; further, the support 3 is rotatable about an axis such as to be arranged such as to maximise a quantity of solar rays R which reflect against the reflective surface 6 and are conveyed towards the photovoltaic cell 4 and in order to regulate the direction of the light beam 50 emitted outwards from the artificial light source 5.

The lighting group 1, 10 is advantageously particularly compact and inexpensive with respect to the prior art. In fact, the artificial light source 5 is constrained to the support 3 to which the photovoltaic cell 4 is also constrained.

Further, the proposed solution has been shown to be particularly flexible and versatile, as it enables regulating the light beam 50 emitted by the artificial light source 5 towards the outside, according to needs.

In particular, the movement (rotatable) of the support 3 with respect to the frame 2 can be limited to a degree of freedom. In other words, the support 3 is hinged to the frame 2 at a hinge axis. In particular, the hinge axis passes through the support 3.

The photovoltaic cell 4 and the source of artificial light 5, on the other hand, can be for example constrained to the support 3 so as to be fixed thereto.

In particular, in the accompanying figures the support 1 forms a box element comprising at least a transparent surface 30 (for example made of glass or plastic) for protection, in order to enable access of the solar rays R and outlet of the light beam 50 emitted by the source of artificial light 5.

In the preferred embodiment of the invention, the group 1, 10 comprises a plurality of photovoltaic cells 4 and a plurality of sources of artificial light 5.

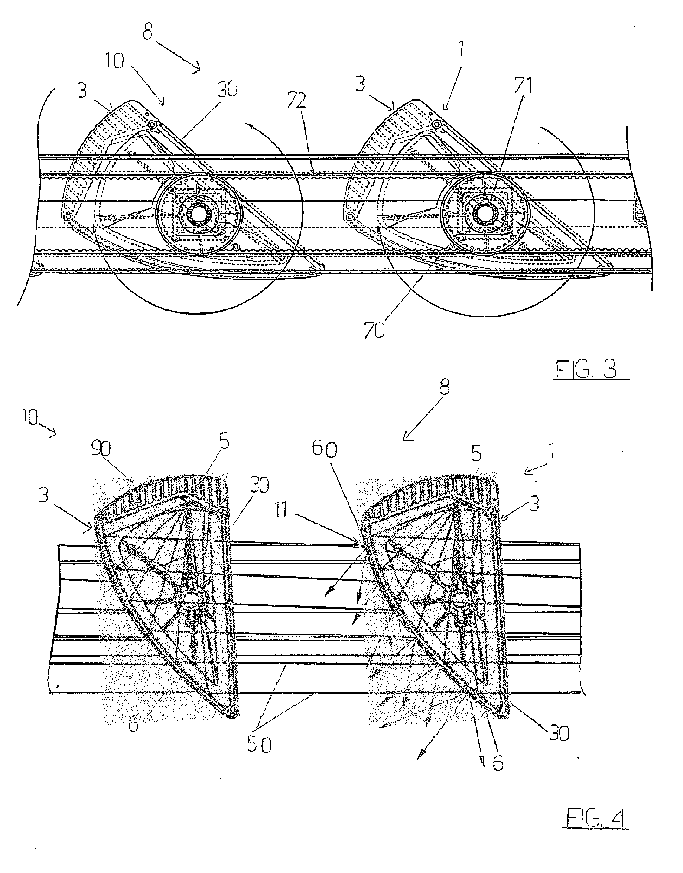

The group 1, 10 of the present invention can further comprise movement means 7 (see figure 3) for enabling the movement of the support 3 (and therefore the solid movement of the photovoltaic cells 4 and the artificial light source 5) with respect to the frame 2.

The movement means 7 can comprise for example at least a pulley 70 having a double belt or double chain 72 and at least a hollow shaft 71 (arranged at the above-mentioned hinge axis) connected to the pulley 70 and the support, activatable to enable rotation of the support 3 with respect to the frame 2 (see in particular the arrows of figure 3).

The movement means 7 can comprise at least an engine (not illustrated) for enabling movement of the pulley 71, with the aim of enabling "solar tracking" of the support 3; in this way it is possible to maximise the quantity of solar rays R which, reflecting against the reflective surface 6, are conveyed towards the photovoltaic cell 4.

Further, the movement means 7 can comprise a manual movement system (not illustrated), in order to enable movement of the pulley 71 with the aim of regulating the direction of the support 3 and therefore of the light beam 50 emitted by the source of artificial light 5.

For example, the light beam 50 can be regulated to illuminate the front of a building at night.

With reference to the figures, the source of artificial light 5 is arranged adjacent or in a relation of strict vicinity with respect to the photovoltaic cell 4. In detail, the source of artificial light 5 can be arranged at a minimum distance from the photovoltaic cell 4.

In the detail illustrated in figure 5, a plurality of photovoltaic cells 4 (for example made of silicon) can be provided, arranged in at least a row. Still with reference to the detail of figure 5, a plurality of artificial light sources 5 is included, in particular one for each two photovoltaic cells 4.

The reflective surface 6 can exhibit, for example, a parabolic profile (as in the case illustrated in the appended figures). Specifically, the reflective surface 6 can comprise at least a reflective surface, which for example is identified in a reflective film.

In a preferred embodiment of the invention, each artificial light source 5 comprises at least a LED.

This detail advantageously enables not only modulating the light intensity of the at least a LED without modifying the chromatic performance of the source (by means of a suitable control board), but also reducing the energetic consumption, as well as reducing the maintenance intervals and replacement of the light sources to a minimum.

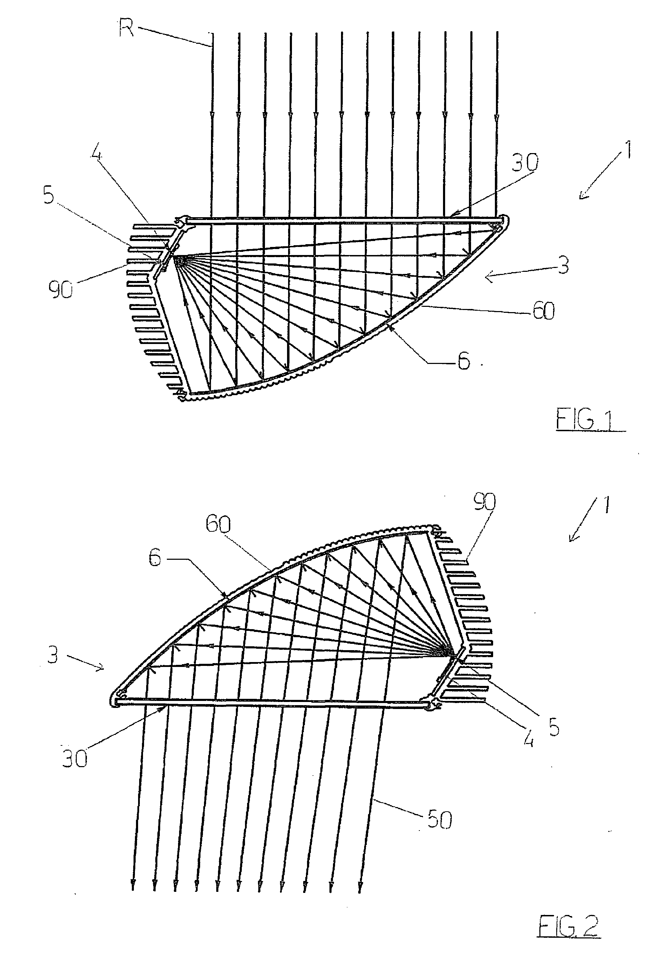

In the embodiment of the invention, the support 3 further comprises means for dissipating the heat, arranged at the photovoltaic cell 4 in order to prevent over-heating. The heat dissipating means can comprise a plurality of fins, visible for example in figures 1 and 2.

In a preferred embodiment, the heat dissipating means further comprise at least a conduit (not illustrated) for passage of a cooling fluid, arranged adjacent to the fins 90.

The fluid flowing in the conduit can be further used for conversion of the solar radiation into heat energy usable for example in civil or industrial situations.

In a different embodiment, the conduit can alternatively be arranged internally of the support 3.

In a preferred embodiment of the invention, the support 3 can further comprise a conduit (not illustrated) arranged such as to dispense a fluid (for example water) at the transparent surface 30 of the support 3, in order to enable periodic cleaning thereof.

The group 1, 10 can further comprise a battery (not illustrated) for accumulating the electrical energy via the photovoltaic cell 4. In this case, at least a light source 5 can be connected to the battery, in order to be supplied thereby. This detail enables using the group 1, 10 also in places where the connection of the electric distribution network is hard to achieve or absent.

The present invention further relates to a system 8 comprising a plurality of groups 1, 10 as described herein above.

In particular, in the embodiment illustrated in figures 3 and 4, the plurality of groups 1, 10 comprises at least a first group 1 and a second group 10.

In the specific case, at least the support 3 of the first group 1, comprises a wall 11 which on a side thereof is provided with the reflective surface 6 and which on the opposite side is provided with a diffusing surface 60 designed to create a diffused light when a light beam 50 reflects against the diffusing surface 60.

Further, the support 3 of the first group 1 and the support 3 of the second group 10 are arranged adjacent such that a light beam 50 emitted by the artificial light source 5 of the second group 10 and which reflects against the reflective surface 6 of the second group 10 is further reflected, subsequently, from the diffusion surface 60 of the support of the first group 1 such as to create a diffused light (see in particular figure 4).

The system 8 can clearly comprise more than two groups 1, 10 arranged adjacent (such that the relative hinge axes are aligned), the support 3 of each of which can comprise the wall 11 which on a side thereof is provided with the reflective surface 6 and which on the opposite side is provided with a diffusion surface 60.

This characteristic advantageously makes the invention more versatile with respect to the prior art, especially in the preferred embodiment in which the reflective surface 6 exhibits a parabolic profile. In fact, according to needs it is practically and rapidly possible to obtain both a direct light (see figure 2) and a diffused light (as in the case of figure 4) according to the rotation of each group 1, 10 with respect to the frame 2.

The present invention further relates to a sun shade comprising a system 8 such as the one described above. In this case, the support 3 of each group 1, 10 is a sunshade fin, comprising a housing having a longitudinal development (see in particular figure 6).

For example, the sunshade cover can be used for realising a veranda. In this case, the groups 1,10 can be used for generating electrical energy during the day when there is a clear sky, while in the evening, at night and/or during the day, with the sky cloudy, they can be used as a source of illumination.

Further, the invention relates to a roof and a canopy both comprising the above-described sunshade.

The system 8 of the present invention is advantageously not only versatile but also poly-functional according to needs and/or meteorological conditions.

The foregoing has been described by way of non-limiting example, and any eventual constructional variants are understood to fall within the protective scope of the present technical solution, as claimed in the following.

## Claims

1. A lighting group (1, 10), comprising:
a frame (2); a support (3) which is constrained to the frame (2); a photovoltaic cell (4) which is constrained to the support (3); an artificial light source (5);
**characterised in that**:
the support (3) is provided with a reflective surface (6) arranged and conformed such as to convey solar rays (R) towards the photovoltaic cell (4);
the artificial light source (5) is constrained to the support (3) such as to emit a light beam (50) which reflects against the reflective surface (6) and propagates towards the outside;
the support (3) is rotatable about an axis such as to be arranged such as to maximise a quantity of solar rays (R) which reflect against the reflective surface (6) and are conveyed towards the photovoltaic cell (4) and in order to regulate the direction of the light beam (50) emitted outwards from the artificial light source (5).

2. The group (1, 10) of the preceding claim, wherein the artificial light source (5) is arranged adjacent to or in a relation of strict vicinity with the photovoltaic cell (4).

3. The group (1, 10) of any one of the preceding claims, wherein the reflective surface (6) exhibits a parabolic profile.

4. The group (1, 10) of any one of the preceding claims, wherein the artificial light source (5) comprises at least a LED.

5. A system (8) comprising a plurality of groups (1, 10) according to any one of the preceding claims.

6. The system (8) of the preceding claim, wherein the plurality of groups (1, 10) comprises at least a first group (1) and a second group (10); and wherein;
at least the support (3) of the first group (1) comprises a wall (11) which on a side thereof is provided with the reflective surface (6) and on the opposite side thereof is provided with a diffusing surface (60) designed such as to create a diffused light when a light beam (50) reflects against the diffusing surface (60);
and wherein the support (3) of the first group (1) and the support (3) of the second group (10) are arranged adjacent such that a light beam (50) emitted by the artificial light source (5) of the second group (10) and which reflects against the reflective surface (6) of the second group (10) is further reflected, subsequently, by the diffusing surface (60) of the support (3) of the first group (1) such as to create a diffused light.

7. A sunshade covering comprising a system (8) according to claim 5 or 6, wherein the support (3) of each group (1, 10) is a sunshade slat and comprises a housing having a longitudinal development.

8. A roof comprising the sunshade covering according to the preceding claim.

9. A shelter comprising the sunshade covering according to claim 7.

## Patentansprüche

1. Beleuchtungsgruppe (1, 10), Folgendes beinhaltend:
einen Rahmen (2); eine Halterung (3), die an dem Rahmen (2) festgelegt ist; eine photovoltaische Zelle (4), die an der Halterung (3) festgelegt ist;
eine künstliche Lichtquelle (5);
**dadurch gekennzeichnet, dass**:
die Halterung (3) eine reflektierende Oberfläche (6) aufweist, die derart angeordnet und beschaffen ist, dass sie Sonnenstrahlen (R) zu der photovoltaischen Zelle (4) leitet;
die künstliche Lichtquelle (5) derart an der Halterung (3) festgelegt ist, dass sie einen Lichtstrahl (50) ausgibt, der an der reflektierenden Oberfläche (6) reflektiert wird und sich nach außen hin ausbreitet;
die Halterung (3) derart um eine Achse drehbar ist, dass sie angeordnet werden kann, um die Menge der Sonnenstrahlen (R) zu maximieren, die an der reflektierenden Oberfläche (6) reflektiert und zu der photovoltaischen Zelle (4) geleitet werden, und um die Richtung des von der künstlichen Lichtquelle (5) nach außen ausgegebenen Lichtstrahls (50) zu regulieren.

2. Gruppe (1, 10) nach dem vorhergehenden Anspruch, worin die künstliche Lichtquelle (5) angrenzen an oder in einer Beziehung größter Nähe zu der photovoltaischen Zelle (4) angeordnet ist.

3. Gruppe (1, 10) nach einem der vorhergehenden Ansprüche, worin die reflektierende Oberfläche (6) ein parabolisches Profil aufweist.

4. Gruppe (1, 10) nach einem der vorhergehenden Ansprüche, worin die künstliche Lichtquelle (5) zumindest eine LED beinhaltet.

5. System (8), mehrere Gruppen (1, 10) nach einem der vorhergehenden Ansprüche beinhaltend.

6. System (8) nach dem vorhergehenden Anspruch, worin die mehreren Gruppen (1, 10) zumindest eine erste Gruppe (1) und eine zweite Gruppe (10) beinhalten; und worin:
zumindest die Halterung (3) der ersten Gruppe (1) eine Wand (11) beinhaltet, die auf einer ihrer Seiten eine reflektierende Oberfläche (6) aufweist und auf der gegenüberliegenden Seite eine diffundierende Oberfläche (60) aufweist, die dafür ausgelegt ist, ein gestreutes Licht zu erzeugen, wenn ein Lichtstrahl (50) an der diffundierenden Oberfläche (60) reflektiert wird;
und worin die Halterung (3) der ersten Gruppe (1) und die Halterung (3) der zweiten Gruppe (10) derart aneinander angrenzend angeordnet sind, dass ein Lichtstrahl (50), der von der künstlichen Lichtquelle (5) der zweiten Gruppe (10) ausgegeben und an der reflektierenden Oberfläche (6) der zweiten Gruppe (10) reflektiert wird, anschließend weiter von der diffundierenden Oberfläche (60) der Halterung (3) der ersten Gruppe (1) reflektiert wird, so dass er ein gestreutes Licht erzeugt.

7. Sonnenschutzabdeckung, beinhaltend ein System (8) nach Anspruch 5 oder 6, worin die Halterung (3) jeder Gruppe (1, 10) eine Sonnenschutzlamelle ist und ein Gehäuse mit längsgerichteter Ausdehnung aufweist.

8. Dach, beinhaltend die Sonnenschutzabdeckung nach dem vorhergehenden Anspruch.

9. Schutzdach, beinhaltend die Sonnenschutzabdeckung nach Anspruch 7.

## Revendications

1. Un groupe d'éclairage (1, 10), comprenant:
un châssis (2); un support (3) qui est assujetti au châssis (2); une cellule photovoltaïque (4) qui est assujettie au support (3); une source de lumière artificielle (5);
**caractérisé en ce que**:
le support (3) est doté d'une surface réflectrice (6) disposée et conformée de manière à véhiculer des rayons solaires (R) vers la cellule photovoltaïque (4) ;
la source de lumière artificielle (5) est assujettie au support (3) de manière à émettre un faisceau lumineux (50) qui se réfléchit contre la surface réflectrice (6) et se propage vers l'extérieur ;
le support (3) peut tourner autour d'un axe de manière à être disposé pour maximiser une quantité de rayons solaires (R) qui se réfléchissent contre la surface réflectrice (6) et sont véhiculés vers la cellule photovoltaïque (4) et de manière à régler la direction du faisceau lumineux (50) émis vers l'extérieur par la source de lumière artificielle (5).

2. Le groupe (1, 10) selon la revendication précédente, dans lequel la source de lumière artificielle (5) est disposée adjacente à ou dans une relation de stricte proximité avec la cellule photovoltaïque (4).

3. Le groupe (1, 10) selon l'une quelconque des revendications précédentes, dans lequel la surface réflectrice (6) présente un profil parabolique.

4. Le groupe (1, 10) selon l'une quelconque des revendications précédentes, dans lequel la source de lumière artificielle (5) comprend au moins une DEL.

5. Un système (8) comprenant une pluralité de groupes (1, 10) selon l'une quelconque des revendications précédentes.

6. Le système (8) selon la revendication précédente, dans lequel la pluralité de groupes (1, 10) comprend au moins un premier groupe (1) et un deuxième groupe (10) ; et dans lequel:
au moins le support (3) du premier groupe (1) comprend une paroi (11) qui est dotée, sur un côté de celle-ci, de la surface réflectrice (6) et, sur le côté opposé de celle-ci, d'une surface diffusante (60) conçue de manière à créer une lumière diffuse quand un faisceau lumineux (50) se réfléchit contre la surface diffusante (60) ;
et dans lequel le support (3) du premier groupe (1) et le support (3) du deuxième groupe (10) sont disposés adjacents de manière à ce qu'un faisceau lumineux (50) émis par la source de lumière artificielle (5) du deuxième groupe (10) et qui se réfléchit contre la surface réflectrice (6) du deuxième groupe (10) soit également renvoyé, successivement, par la surface diffusante (60) du support (3) du premier groupe (1) afin de créer une lumière diffuse.

7. Une couverture brise-soleil comprenant un système (8) selon la revendication 5 ou 6, dans laquelle le support (3) de chaque groupe (1, 10) est une lame brise-soleil et comprend un logement ayant un développement longitudinal.

8. Un toit comprenant la couverture brise-soleil selon la revendication précédente.

9. Un abri comprenant la couverture brise-soleil selon la revendication 7.
